# EUROPÄISCHE PATENTANMELDUNG

(11) **EP 2 187 721 A1**
(43) Veröffentlichungstag der Anmeldung: **19.05.2010**
(21) Anmeldenummer: 08020011.6
(22) Anmeldetag: 17.11.2008
(51) Int. Cl.: H05K 7/14

(54) **Anordnung mit einem Baugruppenträger und einer Baugruppe**

(71) Anmelder: Siemens Aktiengesellschaft, 80333 München (DE)
(72) Erfinder: Mirwald, Werner, 76437 Rastatt (DE)

(57) **Zusammenfassung**

Die Erfindung betrifft eine Anordnung mit einem Baugruppenträger und mit mindestens einer elektronischen Baugruppe, wobei die Baugruppe (10) mit einer Verriegelung zum Verriegeln der Baugruppe im Baugruppenträger und mit mindestens einem Versorgungskontakt zum Anschließen an eine Stromversorgung versehen ist. Es werden geeignete Maßnahmen vorgeschlagen, wodurch die Anordnung für einen Einsatz in einem explosionsgefährdeten Bereich geeignet ist.

## Beschreibung

Die Erfindung betrifft eine Anordnung mit einem Baugruppenträger und mit mindestens einer elektronischen Baugruppe, wobei die Baugruppe mit einer Verriegelung zum Verriegeln der Baugruppe im Baugruppenträger und mit mindestens einem Versorgungskontakt zum Anschließen an eine Stromversorgung versehen ist. Darüber hinaus betrifft die Erfindung eine Baugruppe, welche für einen Einsatz in einer derartigen Anordnung geeignet ist.

Eine derartige Anordnung ist aus dem Siemens-Katalog ST 70, Ausgabe 2007, Seiten 5/2 und 5/112 bekannt. Dort weist ein Automatisierungsgerät mehrere Baugruppen und einen mit einem Rückwandbus versehenen Baugruppenträger auf, der zur Aufnahme der Baugruppen vorgesehen ist. Die Baugruppen sind in Steckplätze des Rückwandbusses steckbar und über den Rückwandbus elektrisch miteinander verbunden, wobei gewöhnlich Peripherie-Baugruppen über diesen Rückwandbus, CPU- oder Kommunikations-Baugruppen über eine geeignete Einspeisung an ihrer Vorderseite mit einer Betriebsspannung versorgt werden. Die Baugruppen werden in der Art und Weise auf den Baugruppenträger montiert, indem die jeweilige Baugruppe zunächst auf den Baugruppenträger aufgeschwenkt wird, wodurch ein mit Kontakten versehenes Steckverbindungsteil der Baugruppe in ein dazu korrespondierendes, ebenfalls mit Kontakten versehenes Steckverbindungsteil des Rückwandbusses eingreift. Anschließend wird die jeweilige Baugruppe an den Baugruppenträger mittels einer Verriegelung festgeschraubt. Dazu weist die Baugruppe an ihrer oberen und unteren Kante einen Schraubbolzen auf, der jeweils in dazu vorgesehene Bohrungen des Baugruppenträgers eingeschraubt wird. Maßnahmen zum Einsatz derartiger Baugruppen in einem explosionsgefährdeten Bereich sind nicht vorgesehen.

Aus der EP 1 108 273 B1 ist eine explosionsgeschützte Steckverbindungsanordnung bekannt, welche zwei Steckverbinderleisten aufweist, über die im zusammengesteckten Zustand der Strom von einer Stromquelle zu einem Verbraucher fließt. Zwischen einer Steckverbinderleiste und der Stromquelle bzw. dem Verbraucher sitzt eine Schaltereinrichtung, deren Steuersignal ebenfalls über die beiden Steckverbinderleisten führt. Dadurch, dass die Kontakte für einen Hauptstromkreis voreilen, während die Kontakte für einen Steuerstrom nacheilen, ist der Hauptstromkreis bereits geschlossen, ehe der Steuerstromkreis eingeschaltet wird. Aufgrund dessen wird ein Stromfluss im Hauptstromkreis beim Stecken oder Trennen der Kontakte des Hauptstromkreises verhindert.

Der vorliegenden Erfindung liegt die Aufgabe zugrunde, eine Anordnung der eingangs genannten Art zu schaffen, welche für einen Einsatz in einem explosionsgefährdeten Bereich geeignet ist. Darüber hinaus ist eine Baugruppe anzugeben, welche für einen Einsatz in einer derartigen Anordnung geeignet ist.

Diese Aufgabe wird im Hinblick auf die Anordnung durch die im kennzeichnenden Teil des Anspruchs 1 angegebenen und im Hinblick auf die Baugruppe durch die im kennzeichnenden Teil des Anspruchs 4 angegebenen Maßnahmen gelöst.

Vorteilhaft ist, dass die ohnehin vorhandene Verriegelung, z. B. die Verriegelung in Form eines Schraubbolzens der Baugruppe, für das Zu- oder Abschalten der Strom- bzw. Spannungsversorgung genutzt wird. Ferner kann auf voreilende und nacheilende Kontakte verzichtet werden, um einerseits beim Stecken der Baugruppe erst dann einen Stromfluss über die beiden Steckverbindungsteile zu ermöglichen, falls eine elektrisch leitende Verbindung zwischen diesen beiden Steckverbindungsteilen besteht, und andererseits beim Ziehen der Baugruppe einen Stromfluss über die beiden Steckverbindungsteile zu verhindern, falls noch eine elektrisch leitende Verbindung zwischen diesen beiden Steckverbindungsteilen besteht. Erst beim Verriegeln einer bereits gesteckten Baugruppe wird diese mit einem geeigneten Strom bzw. einer geeigneten Spannung versorgt. Darüber hinaus wird bereits beim Lösen der Verriegelung - also noch bei gesteckter Baugruppe - die Stromzufuhr wieder unterbrochen bzw. die Spannung wieder abgeschaltet. Nach der Entriegelung kann die Baugruppe wie üblich von dem Baugruppenträger entfernt werden.
Die Baugruppe kann zum Schutz vor Beschädigungen einer in der Baugruppe enthaltenen Leiterplatte und/oder zum Schutz weiterer in dieser Baugruppe angeordneter mechanischer und/oder elektrischer und/oder elektronischer Bauteile als umhüllendes Gehäuse bzw. umhüllende Gehäusekapsel ausgebildet sein, das bzw. die auf einen Rückwandbus eines Baugruppenträgers steckbar ist. Dieses Gehäuse bzw. diese Gehäusekapsel kann selbstverständlich mehrere Leiterplatten aufweisen, welche über einen baugruppeninternen Rückwandbus miteinander verbunden sind, wobei die Baugruppe auf einen Rückwandbus eines Baugruppenträgers steckbar ist und wobei über diesen Rückwandbus gesteckte Baugruppen kommunizieren.

Weitere vorteilhafte Ausgestaltungen der Erfindung ergeben sich aus den weiteren Unteransprüchen.

Anhand der Zeichnung, in der ein Ausführungsbeispiel der Erfindung veranschaulicht ist, werden im Folgenden die Erfindung, deren Ausgestaltungen sowie Vorteile näher erläutert.

Es zeigen:
- Figur 1: einen Ausschnitt von einer Anordnung mit einer Baugruppe und einem baugruppeninternen Rückwandbus,
- Figur 2: Steckanschlüsse einer Baugruppe und eines Rückwandbusses eines Baugruppenträgers,
- Figur 3: eine Anordnung mit einem Baugruppenträger und einer Baugruppe und
- Figur 4: eine Baugruppe.

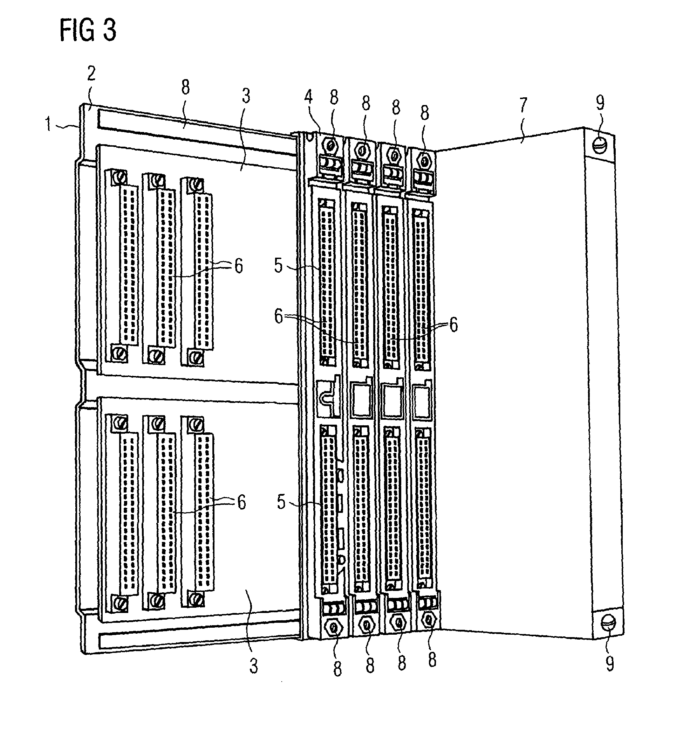

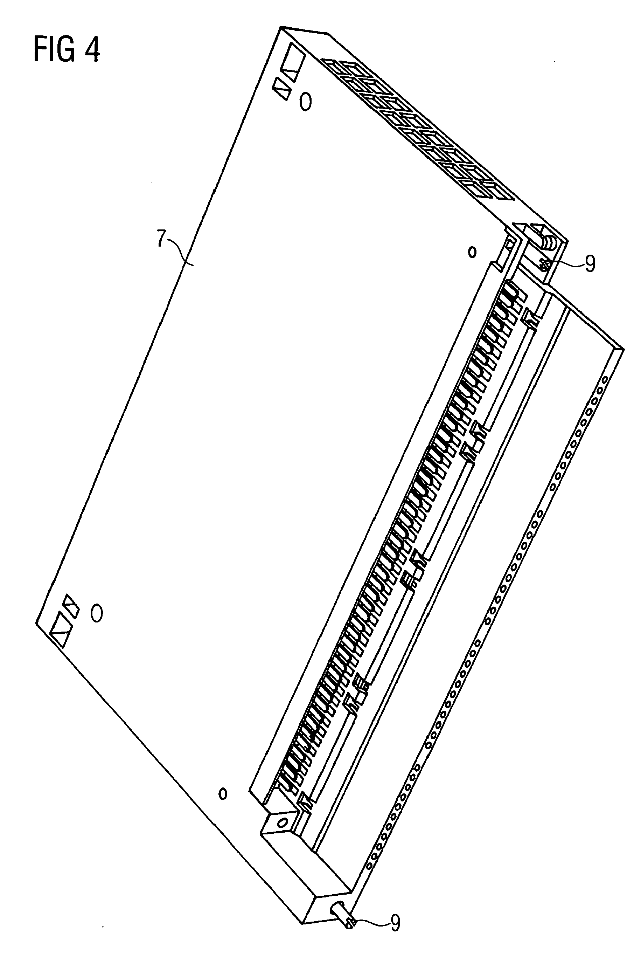

Es wird zunächst auf die Figuren 3 und 4 verwiesen, in welchen ein an sich bekannter Baugruppenträger 1 eines Automatisierungsgerätes sowie eine an sich bekannte Baugruppe für einen derartigen Baugruppenträger dargestellt sind. Die in den Figuren 3 und 4 dargestellten gleichen Teile sind mit gleichen Bezugszeichen versehen.
Bestandteile dieses Baugruppenträgers 1 sind ein Aluminiumträger 2, zwei auf diesen Aluminiumträger 2 montierte Busleiterplatten 3 (Rückwandbus) sowie ein Kunststoffträger 4, durch dessen Öffnungen 5 Steckanschlüsse 6 der Busleiterplatten 3 zur Anschlussseite des Baugruppenträgers 1 ragen. Die Busleiterplatten 3 weisen hier nicht dargestellte Signal- und Stromversorgungsleiterbahnen auf, welche mit den Steckanschlüssen 6 verbunden sind, wobei die Baugruppen zu diesen Steckanschlüssen 6 korrespondierende Steckanschlüsse zum Anschluss an die Steckanschlüsse 6 des Baugruppenträgers 1 aufweisen. Im dargestellten Ausführungsbeispiel ist lediglich eine auf den Baugruppenträger 1 gesteckte Peripherie-Baugruppe 7 gezeigt, die auf einen der Steckanschlüsse 6 montiert ist, wobei in Figur 4 diese Peripherie-Baugruppe 7 ohne aufgesteckten Prozessstecker dargestellt ist. Diese Peripherie-Baugruppe 7 wird über entsprechende Versorgungsleiterbahnen der Busleiterplatten 3, über Kontakte des Steckanschlusses 6 und über dazu korrespondierende Kontakte eines auf diesen Steckanschluss 6 gesteckten Steckanschlusses der Peripherie-Baugruppe 7 mit einer geeigneten Betriebsspannung versorgt, welche eine in den Baugruppenträger 1 steckbare Stromversorgungs-Baugruppe in die Busleiterplatten 3 einspeist. So genannte CPU- bzw. Zentral-Baugruppen und oder Kommunikations-Baugruppen werden dagegen gewöhnlich von dieser Stromversorgungs-Baugruppe über geeignete frontseitige Steckanschlüsse dieser Baugruppen mit elektrischer Energie versorgt.
Der Kunststoffträger 4 ist mit Bohrungen 8 versehen, in welche jeweils ein in Richtung Steckanschluss 6 bzw. Baugruppenträger 1 federnder Schraubbolzen 9 einer in den Steckanschluss 6 eingesteckten Baugruppe eingeschraubt werden kann, um die Baugruppe auf dem Baugruppenträger 1 festzuschrauben bzw. zu verriegeln.

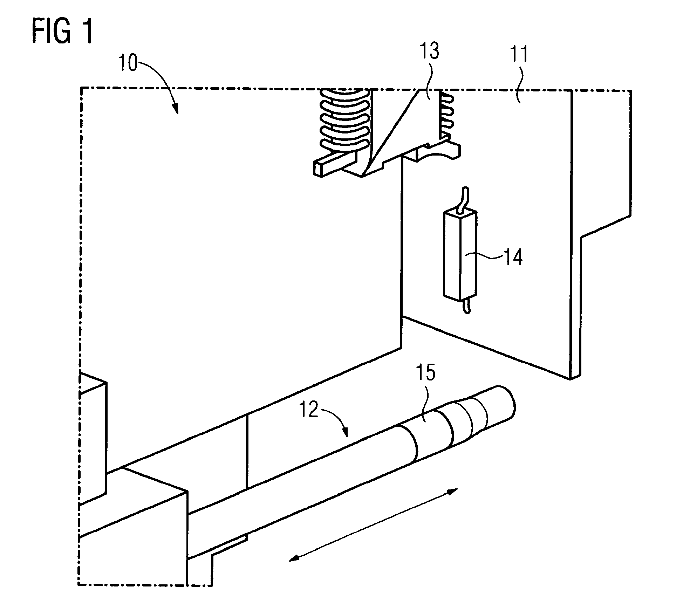

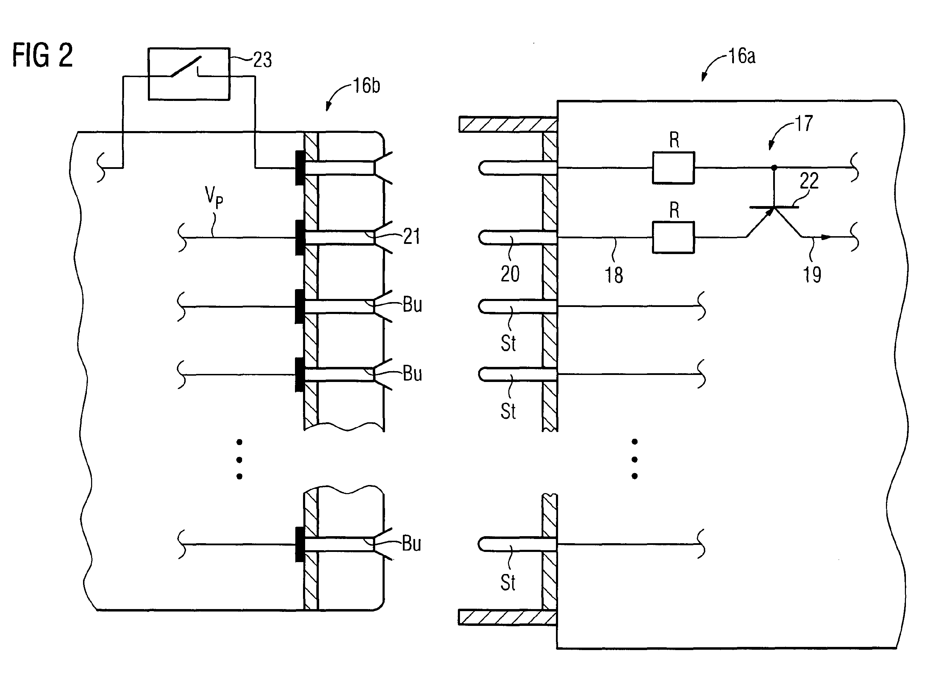

Um zu ermöglichen, dass erst nach dem Verriegeln einer bereits gesteckten Baugruppe 10 diese mit einem geeigneten Strom bzw. einer geeigneten Spannung über eine Busleiterplatte 11 oder über einen frontseitigen Anschluss der Baugruppe 10 versorgt wird, weist ein Schraubbolzen 12 dieser Baugruppe 10 an einer der Busleiterplatte 11 (Rückwandbus) zugewandten Seite einen Magneten 15 auf (Figur 1), welcher zum Betätigen bzw. Schalten eines in einem Bereich eines Steckanschlusses 13 der Busleiterplatte 11 angeordneten Magnetschalters 14 vorgesehen ist. Die Baugruppe 10 und die Busleiterplatte 11 können zusammen in einem Gehäuse bzw. in einer Gehäusekapsel untergebracht sein, das bzw. die auf einen Baugruppenträger montierbar ist. Für den Fall, dass der Schraubbolzen 12 in die Bohrung eines hier nicht dargestellten Baugruppenträgers eingeschraubt ist und die Baugruppe 10 auf dem Baugruppenträger verriegelt, bewirkt das Magnetfeld des Magneten 15 aufgrund seiner Nähe zum Magnetschalter 14, dass der Magnetschalter 14 sich schließt.
In diesem Zusammenhang wird auf Figur 2 verwiesen, in welcher ein Steckanschluss 16a einer Baugruppe und ein zu diesem Steckanschluss 16a korrespondierender Steckanschluss 16b eines Rückwandbusses schematisch dargestellt sind. Der Steckanschluss 16a der Baugruppe weist eine Schalteinrichtung 17 mit einem Eingang 18 und einem Ausgang 19 auf, wobei die Schalteinrichtung 17 über einen Versorgungskontakt 20 in Form eines Stiftes des Steckanschlusses 16a und über einen Versorgungskontakt 21 in Form einer Buchse des Steckanschlusses 16b an ein Versorgungspotential Vp des Rückwandbusses angeschlossen ist. Die mit Widerständen R und einem Transistor versehene Schalteinrichtung 17 ist derart schaltbar, dass diese in einem Schaltzustand zwischen ihrem Eingang 18 und ihrem Ausgang 19 hochohmig und in einem anderen Schaltzustand zwischen ihrem Eingang 18 und ihrem Ausgang 19 niederohmig ist. Die Steckanschlüsse 16a, 16b weisen selbstverständlich weitere Stifte St bzw. mit diesen Stiften St in Wirkverbindung stehende Buchsen Bu zur Übertragung von Signalen zwischen dem Rückwandbus und der Baugruppe auf. Für den Fall, dass die Baugruppe auf den Rückwandbus gesteckt ist, greifen zunächst die Stifte St, 20 des Steckanschlusses 16a der Baugruppe in die Buchsen Bu, 21 des Steckanschlusses 16b des Rückwandbusses ein (nicht dargestellt). Der Schaltzustand zwischen dem Eingang 18 und dem Ausgang 19 der Schalteinrichtung 17 ist noch hochohmig, weil ein steuerbarer Schalter in Form des Transistors 22 sperrt. In diesem Schaltzustand sind am Ausgang 19 angeschlossene Schaltungsteile bzw. eine am Ausgang angeschlossene Last der Baugruppe strom- bzw. spannungslos, dort liegt kein Versorgungspotential an. Wird die auf den Rückwandbus gesteckte Baugruppe auf einen Baugruppenträger nun festgeschraubt, schließt aufgrund eines an einer Verriegelung der Baugruppe angeordneten Magneten ein Magnetschalter 23 des Baugruppenträgers. Dadurch wird der Transistor 22 mittels eines vom Magnetschalter 23 durchgeschalteten Steuersignals angesteuert, wodurch dieser einen niederohmigen Schaltzustand einnimmt und durchschaltet, so dass das Versorgungspotential Vp am Ausgang 19 anliegt.

Anstatt eines Schraubbolzens ist es selbstverständlich möglich, einen an einer Baugruppe angeordneten Exzenter zur Verriegelung dieser Baugruppe an einem Baugruppenträger vorzusehen. In diesem Fall ist der Magnetschalter, z. B. ein Magnetschalter in Form eines Reed-Kontaktes bzw. Reed-Schalters, auf der Baugruppe angeordnet, wobei im Rahmen einer Drehbewegung des Exzenters ein am Exzenter montierter Magnet den Reed-Schalter schaltet.

## Patentansprüche

1. Anordnung mit einem Baugruppenträger (11) und mit mindestens einer elektronischen Baugruppe (10), wobei die Baugruppe (10)
- mit einer Verriegelung (12) zum Verriegeln der Baugruppe (10) im Baugruppenträger und
- mit mindestens einem Versorgungskontakt (20) zum Anschließen an ein Versorgungspotential (Vp) versehen ist,
**dadurch gekennzeichnet,**
- **dass** die Baugruppe (10) eine mit mindestens einem Ein- und einem Ausgang (18, 19) versehene Schalteinrichtung (17) aufweist, wobei die Schalteinrichtung in einem Schaltzustand zwischen ihrem Eingang (18) und ihrem Ausgang (19) hochohmig und in einem anderen Schaltzustand zwischen ihrem Eingang (18) und ihrem Ausgang (19) niederohmig ist und wobei die Schalteinrichtung (17) mit ihrem Ein- oder Ausgang (18, 19) an den mindestens einen Versorgungskontakt (20) angeschlossen ist, und
- **dass** der Baugruppenträger oder ein Rückwandbus (11) oder die Baugruppe (10) mit einem Magnetschalter (23) zum Schalten der Schalteinrichtung (17) versehen ist und die Verriegelung (12) einen Magneten (15) zum Betätigen des Magnetschalters (23) aufweist.

2. Anordnung nach Anspruch 1, **dadurch gekennzeichnet, dass** die Verriegelung ein federnder Schraubbolzen (12) ist.

3. Anordnung nach Anspruch 1, **dadurch gekennzeichnet, dass** die Verriegelung (12) ein Exzenter ist.

4. Baugruppe zum Anschluss an einen Baugruppenträger, wobei
- die Baugruppe (10) mit einer Verriegelung (12) zum Verriegeln der Baugruppe (10) im Baugruppenträger versehen ist,
- die Baugruppe (10) mit mindestens einem Versorgungskontakt (20) zum Anschließen an ein Versorgungspotential (Vp) versehen ist,
**dadurch gekennzeichnet,**
- **dass** die Baugruppe (10) eine mit mindestens einem Ein- und einem Ausgang (18, 19) versehene Schalteinrichtung (17) aufweist, wobei die Schalteinrichtung (17) in einem Schaltzustand zwischen ihrem Eingang (18) und ihrem Ausgang (19) hochohmig und in einem anderen Schaltzustand zwischen ihrem Eingang (18) und ihrem Ausgang (19) niederohmig ist und wobei die Schalteinrichtung (17) mit ihrem Ein- oder Ausgang (18, 19) an den mindestens einen Versorgungskontakt (20) angeschlossen ist, und
- **dass** die Verriegelung (12) einen Magneten (15) zum Betätigen eines Magnetschalters (23) des Baugruppenträgers oder des Rückwandbusses (11) oder der Baugruppe (10) aufweist, wobei der Magnetschalter (23) zum Schalten der Schalteinrichtung (17) vorgesehen ist.

5. Baugruppe nach Anspruch 4, **dadurch gekennzeichnet, dass** die Verriegelung ein federnder Schraubbolzen (12) ist.

6. Baugruppe nach Anspruch 4, **dadurch gekennzeichnet, dass** die Verriegelung (12) ein Exzenter ist.
